# EUROPÄISCHE PATENTANMELDUNG

(11) **EP 3 096 186 A2**
(43) Veröffentlichungstag der Anmeldung: **23.11.2016**
(21) Anmeldenummer: 16161954.9
(22) Anmeldetag: 07.11.2014
(51) Int. Cl.: G03F 7/20

(54) **LITHOGRAFIEBELICHTUNGSEINRICHTUNG ZUR LITHOGRAPHISCHEN BELICHTUNG DURCH EIN- ODER MEHRSTUFIGE LASERPROJEKTIONSEINHEITEN MIT EINER ODER MEHREREN WELLENLÄNGEN**

(30) Priorität: 08.11.2013 DE 102013018773
(62) Teilanmeldung aus: 14192305.2
(71) Anmelder: Limata GmbH, 85737 Ismaning (DE)
(72) Erfinder: Nagel, Matthias, 85737 Ismaning (DE); Schönhuber, Johann, 83125 Eggstätt (DE); Heim, Attila, 85649 Brunnthal (DE)
(74) Vertreter: Vossius & Partner Patentanwälte Rechtsanwälte mbB

(57) **Zusammenfassung**

Die Erfindung betrifft eine Lithografiebelichtungseinrichtung zur lithographischen direkten Belichten eines Musters auf einem Substrat (30), das eine lichtempfindliche Schicht im UV Bereich von 350 nm - 450 nm aufweist, sowie ein entsprechendes Verfahren. Die Lithografiebelichtungseinrichtung umfasst eine Belichtungseinrichtung (10) die eine modulierte Lichtquelle mit einer oder mehreren UV-Laserlichtquellen (11) aufweist, zur Erzeugung eines kollimierten UV-Laserlichts (13) im Wellenlängenbereich von 350 nm - 450 nm. Zudem weist die Lithografiebelichtungseinrichtung eine veränderbare Ablenkeinrichtung (12) auf, mit der das kollimierte UV-Laserlicht (13) abgelenkt wir, um das Muster auf das Substrat (30) zu Belichten.

## Beschreibung

### Gebiet der Erfindung

Die vorliegende Erfindung betrifft allgemein eine Belichtungseinrichtung, insbesondere eine Lithografiebelichtungseinrichtung zum Belichten eines mit einer lichtempfindlichen Schicht beschichteten Substrats zur Herstellung einer Leiterplatte bzw. Platine oder eines Formätzteiles, sowie das entsprechende Verfahren zur Belichtung mit der erfindungsgemäßen Lithografiebelichtungseinrichtung. Insbesondere betrifft die Erfindung eine Lithografiebelichtungseinrichtung mit mindestens einem Lichtstrahl, der vorzugsweise von zwei Laserstrahlen unterschiedlicher Wellenlänge gebildet wird, der durch eine veränderbare Ablenkeinrichtung relativ zum Substrat abgelenkt wird, um Strukturen, insbesondere Schaltstrukturen auf dem Substrat zu erzeugen.

### Hintergrund der Erfindung

Eine Leiterplatte (Leiterkarte, Platine) ist ein Träger bzw. Substrat aus isolierendem Material mit festhaftenden leitenden Verbindungen. Eine Leiterplatte dient der mechanischen Befestigung und elektrischen Verbindung elektronischer Bauteile. Die Verbindungsleitungen (Leiterbahnen) werden zumeist durch Masken-Ätzen (geätzte Leiterplatte, engl. etched wiring board = EWB) aus einer dünnen Schicht leitfähigen Materials, beispielsweise Kupfer, auf einem isolierenden Substrat (dem sogenannte Basismaterial) hergestellt.

Bei der Erzeugung von Schaltstrukturen bzw. Verbindungsleitungen mittels Masken-Ätzen wird üblicherweise ein Schaltungsmuster auf einer Abdeckmaske bereitgestellt. Eine lichtempfindliche Schicht (Fotoresist bzw. Fotolack, flüssiger oder pastenförmiger Lötstopplack), die auf einem mit einer leitfähigen Beschichtung versehenen Plattenrohling aufgetragen ist, wird durch die Abdeckmaske belichtet, wodurch das Schaltungsmuster von der Abdeckmaske auf den Fotoresist übertragen wird.

Durch die Belichtung wird die Beschaffenheit des Resists so verändert, dass die belichteten und unbelichteten Strukturen unterschiedlich von einer Entwicklerflüssigkeit lösbar sind. So können nach der Belichtung des Fotoresists durch die Maske mit dem gewünschten Platinenlayout, je nach verwendetem Fotoresist, entweder die belichteten oder die unbelichteten Anteile des Lacks in einer passenden Entwicklerlösung gelöst und entfernt werden. Bringt man die so behandelte Leiterplatte in eine geeignete Ätzlösung (z. B. in Wasser gelöstes Eisen(III)-chlorid oder Natriumpersulfat oder mit Salzsäure+H₂O₂), so wird nur der freigelegte Teil der metallisierten Oberfläche angegriffen; die vom Fotoresist bedeckten Anteile bleiben erhalten, weil der Lack beständig gegen die Ätzlösung ist.

Bei der Belichtung von Schaltungsdruck- oder Lötstopplacken werden die belichteten Bereiche durch die Belichtung (Bestrahlung mit UV-Licht von einer oder mehreren Wellenlänge) derart verändert, polymerisiert, dass sie den nachfolgenden Entwicklungsprozess überstehen. Die nicht belichteten Bereiche werden durch eine Entwicklerflüssigkeit weggespült. Der auf der Leiterplatte übrig gebliebene Lötstopplack verhindert, nach einem folgenden thermischen Backprozess, das fortschwimmen der aufgelegten Bauteile bei dem nachfolgenden Reflowlötprozess. Ebenfalls schützt der Lötstopplack die geätzten Schaltungsstrukturen sowie das Basismaterial vor äußeren Einflüssen. Weiterhin können besondere Farben von Lötstopplack verwendet werden um damit die Eigenschaften der Platine, z.B. die verbesserte Reflektion von Licht, zu steuern.

Für die Belichtung des Fotoresists wird ein Belichtungsmittel mit bestimmten auf das lichtempfindliche Material abgestimmten erforderlichen Strahlungseigenschaften bzgl. Wellenlänge und Intensität eingesetzt. Die meisten handelsüblichen Fotoresits sind besonders empfindlich auf UV-Licht, insbesondere auf Licht im Wellenbereich zwischen 350 nm - 405 nm. Als herkömmliche Belichtungsmittel werden Glühlampen mit hohem UV-Anteil bzw. Leuchtstoffröhren verwendet. Die zum Großteil zur Belichtung eingesetzten Leuchtstoffröhren haben jedoch ein relativ breiteres Spektrum. D.h. ein hoher Anteil des emittierten Lichtes ist im Wellenlängenbereich des sichtbaren Lichtes auf den der Fotoresits nicht empfindlich ist, wodurch der Wirkungsgrad solcher Leuchtstoffröhren nicht optimal ist. Auflösungsbestimmend ist bei den Schaltungsstrukturen der Leiterplattenherstellung nicht die Wellenlänge.

Das Entwerfen der Schaltungsmuster erfolgt heute meist mittels Software am Computer. Dementsprechend gibt es Lithografiebelichtungseinrichtungen, die das Schaltungsmuster direkt mit einer Belichtungseinrichtung auf den Fotoresits übertragen und keine Maske benötigen.

Jedoch ergeben sich einige Nachteile durch die direkte Belichtung von Leiterplatten mit einem zu einem Lichtpunkt gebündelten Laserdiode oder einer LED. Der größte Nachteil ist die lange Prozesszeit bei hochdichten Strukturen. Arbeitet das Verfahren nach einer vektoriellen Verfahrensweise fallen heutzutage bis zu 1.000.000 Fahrbefehle pro Nutzengrösse an. Diese große Anzahl an Positionierungspunkten ermöglicht selbst mit den heutzutage schnellsten mechanischen Positionierungseinheiten in X/Y Fahrtrichtungen keine schnellen Fertigungszeiten. Das Problem liegt hierbei bei der physikalisch begrenzten Beschleunigung- und Abbremsung der zu tragenden Massen am System. Nur selten erreichen die Portalsysteme ihre durch die Leistung der Lichtquelle vorgegebene mögliche Endgeschwindigkeit. Das Verfahren arbeitet zu einem Großteil in der Beschleunigung- und Abbremsphase, wodurch eine schnelle Prozess-Zeit nicht erreichbar ist.

Hinzu kommt die vektorielle Verfahrensweise an sich. Diese macht eine typische Kalkulation der Prozess-Zeit verschiedener Leiterplattenaufträge unmöglich, da die Prozess-Zeit eine Funktion der Komplexität der Leiterplatte ist und diese mit unterschiedlichen Aufträgen aus der Praxis keine Konstante darstellt.

Um einen Laserstrahl schnell abzulenken können heutzutage Prismen oder Spiegel verwendet werden. Dabei wird meist ein Laserstrahl mit einer bestimmten Wellenlänge mittels einer zweidimensionalen Spiegelablenkung bei feststehendem Substrat oder mittels eines eindimensionalen Spiegel- oder Prismen- oder Polygonspiegelablenkung bei gleichzeitiger senkrecht zu Strahlablenkrichtung bewegendem Substrat realisiert. D. h. mit Hilfe der Spiegelablenkung wird ein Muster auf dem zu belichtenden Substrat erzeugt.

Der bei diesen Verfahren auftretende Vorteil im Vergleich zu vektoriellen Belichtungsverfahren liegt darin, dass durch die optische Brennweite, speziell den Abstand zwischen Ablenksystem, ausgangsseitiger Optik und das zu belichtende Substrat, hohe Geschwindigkeiten des Lichtpunktes erreicht werden. Die zu belichtende Struktur wird bei solchen Verfahren durch die elektrische Ansteuerung des Laserstrahls erreicht womit die Bearbeitungszeit unabhängig von der zu belichtenden Struktur ist.

Ebenfalls bieten solche Verfahren den Vorteil mit mehreren Belichtungseinheiten parallel zu arbeiten und somit die Gesamtbelichtungszeit zu verkürzen.

### Zusammenfassung der Erfindung

Die erfindungsgemäße Lithografiebelichtungseinrichtung umfasst eine Belichtungseinrichtung zum Belichten eines Substrats mit lichtempfindlicher Schicht (Fotoresist). Vorzugsweise ist die lichtempfindliche Schicht im UV-Bereich lichtempfindlich, vorzussweise im Bereich von 350nm bis 450nm. Die Belichtungseinrichtung umfasst mindestens eine Lichtquelle, um Licht im vorzugsweise im UV Bereich, vorzugsweise im Wellenlängenbereich 350 nm bis 450 nm abzustrahlen, d.h., vorzugsweise in dem Wellenlängenbereich in dem die lichtempfindliche Schicht sensitiv ist. Vorzugsweise wird das Licht mit einer oder mehreren UV-Laserdioden bzw. Halbleiterlasern erzeugt.

Insbesondere handelt es sich bei der erfindungsgemäßen Belichtungseinrichtung um eine maskenlose Direktbelichtungseinrichtung, mit der Muster bzw. Strukturen aufgrund der Umlenkung des Laserlichtstrahls während der Belichtung direkt auf das Substrat belichtet werden können.

Die Erfindung betrifft allgemein eine Lithografiebelichtungseinrichtung zum lithographischen direkten, vorzugsweise maskenlosen, Belichten eines Musters auf einem Substrat, das eine lichtempfindliche Schicht im UV-Bereich von 350 nm - 450 nm aufweist. Die Lithografiebelichtungseinrichtung weist eine Belichtungseinrichtung auf, wobei die Belichtungseinrichtung eine modulierbare Lichtquelle aufweist mit einer oder mehreren UV-Laserlichtquellen, zur Erzeugung von UV-Laserlichts, vorzugsweise im Wellenlängenbereich von 350 nm - 450 nm, weiter bevorzugt mit einer Wellenlänge von 375nm, 395 nm und/oder 405nm. Vorzugsweise wird das UV-Laserlichts innerhalb und/oder ausserhalb der Belichtungseinrichtung kollimiert, um ein kollimiertes Laserlicht zu erhalten. Zudem weist die Lithografiebelichtungseinrichtung auch eine veränderbare Ablenkeinrichtung auf, die geeignet ist, durch Ablenken des UV-Laserlichts, vorzugsweise durch Ablenken des kollimierten UV-Laserlichts das Muster auf dem Substrat zu belichten.

Eine veränderbare Ablenkeinrichtung kann vorzugsweise auf die Ablenkeinrichtung auftreffendes Licht in Abhängigkeit einer zeitlichen Steuerung in unterschiedlichen Winkeln ablenken. Hierzu kann im einfachsten Fall ein Spiegel dienen, der verschoben oder um eine Achse verstellbar/veränderbar ist. Vorzugsweise kann ein Spiegel aber um mindestens zwei Achsen bzw. zwei Ebenen verstellbar bzw. rotierbar sein. Gemäß weiteren bevorzugten Ausführungsformen können auch mehrere veränderbare Spiegel zur Ablenkung des Lichts dienen. Eine veränderbare Ablenkeinrichtung im Sinne der vorliegenden Erfindung kann auch mit Einrichtungen erfolgen, die nicht mechanisch veränderbar sind, sondern lediglich das Reflexionsverhalten verändern. Beispielsweise kann ein Akusto-optischer-Modulator (AOM) verwendet werden, mit dessen Hilfe sowohl die Intensität als auch die Frequenz von Laserstrahlen moduliert werden kann. Ebenfalls ist es möglich, mittels eines AOM die Richtung des Laserstrahls zu ändern.

Eine weitere im Sinne dieser Erfindung beispielhafte Anwendungsform kann die veränderbare Ablenkeinrichtung mit mindestens einen rotierenden bzw. verkippbaren Polygonspiegel ausgeführt werden, um das UV-Laserlicht an verschiedene Positionen auf dem Substrat abzulenken. Gemäß einer weiteren Ausführungsform kann die veränderbare Ablenkeinrichtung einen ein- oder zwei-dimensionalen Galvometerscanner aufweisen.

Zudem ist es bevorzugt, wenn die Lichtquelle bzw. Laserdiode modulierbar ist, d.h., sie kann vorzugsweise sowohl auf 0%, 100% geschaltet werden und weiter bevorzugt auf beliebige Zwischenstufen ihrer Leistung geschaltet werden. Dies ermöglicht beispielsweise eine bessere, konturgetreue Abbildung von Kanten und schrägen Bahnen.

Gemäß einer weiteren bevorzugten Ausführungsform kann die Belichtungseinrichtung zusätzlich an einer Bewegungseinrichtung angebracht sein, wobei die Bewegungseinrichtung eine Relativbewegung zwischen der Belichtungseinrichtung und dem Substrat erzeugt. Vorzugsweise ist jedoch das Substrat in Bezug zur Umgebung fixiert und die Bewegungseinrichtung bewegt die Belichtungseinrichtung relativ zum Substrat. Im Folgenden soll das ebene Substrat in einer XY-Ebene liegen, wobei die Belichtungseinrichtung durch die Bewegungseinrichtung vorzugsweise in einer Ebene parallel zur XY-Ebene bewegt werden kann (vorzugsweise stehen X-Achse und Y-Achse senkrecht zueinander). Weiter bevorzugt kann die Belichtungseinrichtung durch die Bewegungseinrichtung auch entlang einer zur XY-Ebene senkrechten Z-Achse (vorzugsweise parallel zur Gravitationskraft) bewegt werden. Mit anderen Worten, die Bewegungseinrichtung ist vorzugsweise angepasst, um eine Relativbewegung in einer Dimension, vorzugsweise parallel zum Substrat bzw. senkrecht zum Substrat zu ermöglichen, und/oder eine Relativbewegung in zwei Dimensionen, vorzugsweise parallel zum Substrat, zu ermöglichen, und/oder eine Relativbewegung in drei Dimensionen, vorzugsweise parallel und senkrecht zum Substrat zu ermöglichen.

Gemäß einer bevorzugten Ausführungsform weist die Belichtungseinrichtung mindestens zwei UV-Laserlichtquellen auf, vorzugsweise mindestens zwei UV-Laserdioden.

Beispielsweise ist es bevorzugt, dass die Belichtungseinrichtung bis zu vier UV-Laserdioden oder sogar mehr Laserdioden aufweist und diese jeweils einzeln, weiter bevorzugt paarweise gebündelt über die Ablenkeinrichtung auf das Substrat abgelenkt werden. Mit anderen Worten, sowohl die Ablenkeinrichtung und die einzelnen UV-Laserdioden können einzeln angesteuert werden. Zudem können auch mehrere der UV-Laserdioden gemeinsam, beispielsweise paarweise gebündelt und auch paarweise angesteuert werden.

Zudem ist es bevorzugt, dass zwei UV-Laserlichtquellen bzw. UV-Laserdioden Laserlicht einer unterschiedlichen Wellenlänge emittieren, wobei beide Wellenlängen vorzugsweise im Bereich von 350 nm - 450 nm liegen. Es ist aber auch möglich, dass zwei UV-Laserlichtquellen bzw. UV-Laserdioden Licht in der gleichen Wellenlänge emittieren, dies kann beispielsweise vorteilhaft sein, um die Leistung der Laserlichtquellen bzw. UV-Laserdioden zu erhöhen. Zudem ist es auch möglich mehr als zwei UV-Laserlichtquellen bzw. UV-Laserdioden bereitzustellen, wobei vorzugsweise mindestens zwei oder mehr Lichtquellen Licht in unterschiedlichen Wellenlängen emittieren.

Um das gewünschte Muster auf dem Substrat in einer gewünschten Größe zu Belichten kann zudem eine Bildbearbeitungsvorrichtung für bildverarbeitende Maßnahmen vorgesehen sein, sodass mittels Skalierung, Drehung, Verschiebung und/oder Verkippung das zu belichtende Muster auf dem Substrat verändert bzw. korrigiert werden kann.

Zusätzlich zu den UV-Laserlichtquellen bzw. UV-Laserdioden kann die Belichtungseinrichtung eine oder mehrere weitere Lichtquelle(n) aufweisen, vorzugsweise eine oder mehrere Laserdiode(n), die Licht im sichtbaren und/oder infraroten Wellenlängenbereich emittiert/emittieren. Weiter bevorzugt wird dieses Licht ebenfalls mit der veränderbaren Ablenkeinrichtung auf das Substrat abgelenkt.

Um eine genaue und sichere Belichtung bereitzustellen werden erfindungsgemäß die Lichtstrahlen der mehreren Lichtquellen, vorzugsweise der UV-Laserlichtquellen bzw. UV-Laserdioden mit Hilfe eines optischen Elements zu einem gemeinsamen Lichtstrahl kombiniert. Dieser gemeinsame Lichtstrahl kann dann mit Hilfe der veränderbaren Ablenkeinrichtung auf das Substrat gelenkt werden, als ob der Strahl von einer einzigen Lichtquelle kommt.

Vorzugsweise wird das zu belichtende Substrat nur von einer Seite, vorzugsweise von oben, mit der erfindungsgemäßen Lithografiebelichtungseinrichtung belichtet. Gemäß einer weiteren bevorzugten Ausführungsform kann das Substrat auch von zwei Seiten, beispielsweise von oben und unten bzw. der Seite, beispielsweise von rechts und links belichtet werden. So kann beispielsweise mindestens eine Belichtungseinrichtung oberhalb des Substrats angeordnet sein und mindestens eine Belichtungseinrichtung unterhalb des Substrats angeordnet sein, wobei die beiden Belichtungseinrichtungen vorzugsweise unabhängig voneinander bewegt werden können.

Neben der oben diskutierten Vorrichtung betrifft die Erfindung auch ein Verfahren zum lithographischen direkten, vorzugsweise maskenlosen, Belichten eines Musters auf einem Substrat, das eine lichtempfindliche Schicht im UV Bereich von 350 nm - 450 nm aufweist, mit dem Schritt des Bereitstellens einer Lithografiebelichtungseinrichtung mit mindestens einer Belichtungseinrichtung, die eine modulierte Lichtquelle mit einer oder mehreren UV-Laserlichtquellen aufweist, vorzugsweise zur Erzeugung eines kollimierten UV-Laserlichts im Wellenlängenbereich von 350 nm - 450 nm. Anschließend wird das Substrat relativ zur Lithografiebelichtungseinrichtung so angeordnet, dass das von der Belichtungseinrichtung emittierte UV-Laserlicht auf das Substrat gelenkt werden kann. Dann wird das Substrats mit der Belichtungseinrichtung belichtet, wobei das Muster mittels einer veränderbaren Ablenkeinrichtung durch zeitlich variables Ablenken und/oder modulieren des UV-Laserlichts auf dem Substrat erreicht wird.

Der Abstand zwischen Belichtungseinrichtung und Substrat kann vorzugsweise während der Belichtung verändert werden, wodurch sich dann die Ausdehnung eines auf dem Substrat erzeugten Belichtungsflecks vorzugsweise verändert, wodurch unterschiedlich breite Linien auf dem Substrat belichtet werden.

Die variable Ablenkeinrichtung lenkt das Licht vorzugsweise in den zwei Dimensionen zum Substrat ab, wobei dieser zeitlich variable Ablenkvorgang vorzugsweise mit zwei gleichen Oszillationsfrequenz durchgeführt wird, um unter 45° parallele Linien zu scannen, wodurch die Scangeschwindigkeit um den Faktor √2 erhöht werden kann. Mit anderen Worten, die Ablenkgeschwindigkeit der Scanner kann dadurch gesteigert werden, dass sie nicht unter 90° zu der Bewegungsrichtung einer Linearmechanik arbeiten (eine schnelle und eine langsame Scanachse), sondern beide unter 45° mit der gleichen Geschwindigkeit scannen. Relativ bewegt sich der Laserpunkt durch diese Arbeitsweise schneller, benötigt allerdings auch mehr Laserleistung, um entsprechend auszuhärten.

Die Geschwindigkeit der Bewegungseinrichtung zur Erzeugung einer Relativbewegung zwischen der Belichtungseinrichtung und dem Substrat ist vorzugsweise an die Scan-Geschwindigkeit der variablen Ablenkeinrichtung angepasst, sodass die Relativbewegung der Belichtungseinrichtung zum Substrat in Abhängigkeit der Scan-Geschwindigkeit durchgeführt wird.

Die variable Ablenkeinrichtung hat vorzugsweise für eine Ablenkung entlang einer Y-Achse, die in der Ebene des Substrats liegt, eine erste Spiegelstufe in Form eines Galvanometerspiegel und vorzugsweise für eine Ablenkung entlang einer X-Achse, die in der Ebene des Substrats liegt und senkrecht zur Y-Achse liegt, eine zweite Spiegelstufe, vorzugsweise in Form eines eindimensionalen elektrisch-magnetisch oszillierenden Mikrospiegels.

Gemäß einer weiteren bevorzugten Ausführungsform kann die zweite Spiegelstufe vorzugsweise in Form eines eindimensional arbeitenden Polygonscanners gestaltet sein.

Vorzugsweise ist die Belichtungseinrichtung in mehrfacher Anwendung nebeneinander so zueinander aufgebaut, dass sich beim Scanvorgang eine geschlossene, um die Anzahl der Belichtungseinrichtungen multiplizierte Scanlinien ergibt. Gelingt es durch eine besonders integrierte Bauweise die Belichtungseinheiten so aufzubauen, dass z.B. bei vier Einheiten die einzelnen Scannbereiche sich nahtlos aneinander reihen, ergibt sich eine durchgehende Scannlinie. In der normalen, bisherigen Arbeitsweise ist dies nicht möglich, weswegen mindestens zwei Fahrten (vor und zurück) durchgeführt werden müssen.

Vorzugsweise ist die Belichtungseinrichtung mit einer Strahlaufweitungsoptik versehen, um das UV-Laserlicht, vorzugsweise das kollimierte UV-Laserlicht, auf einen größeren, definierten Durchmesser aufzuweiten.

Vorzugsweise kann die eine oder können die mehreren UV-Laserdioden analog elektrisch, vorzugsweise in Abhängigkeit der Grau-Stufen-Werte der Abbildung einer Einspeisequellen moduliert werden.

Gemäß einer weiteren bevorzugten Ausführungsform kann die eine oder können die mehreren UV-Laserdioden digital elektrisch, vorzugsweise in Abhängigkeit der Grau-Stufen-Werte der Abbildung der Einspeisequellen moduliert werden.

Schließlich kann erfindungsgemäß durch die Überlappung projizierter Einzelbilder und/oder die Schwärzung bzw. Nichtbelichtung überstehender Randbereiche eine Anpassung der Einzelbilder vorzugsweise in der Einspeisequelle vor dem Belichtungsvorgang erfolgen. Bevorzugte alternative und/oder zusätzliche Ausführungsformen der Erfindung sind in den nachfolgenden Aspekten dargestellt.
1. Lithografiebelichtungseinrichtung zum lithographischen direkten, vorzugsweise maskenlosen, Belichten eines Musters (40) auf einem Substrat (30), das eine lichtempfindliche Schicht aufweist, mit:
   einer Belichtungseinrichtung (10), die eine modulierbare Lichtquelle mit einer oder mehreren UV-Laserlichtquellen (11, 17) aufweist, zur Erzeugung eines UV-Laserlichts (13), vorzugsweise im Wellenlängenbereich von 350 nm - 450 nm; und
   einer veränderbaren Ablenkeinrichtung (12), die geeignet ist, durch Ablenken des UV-Laserlichts (13), das Muster (40) auf dem Substrat (30) zu belichten.
2. Lithografiebelichtungseinrichtung nach Aspekt 1, zusätzlich mit einer Bewegungseinrichtung (20) zur Erzeugung einer Relativbewegung zwischen der Belichtungseinrichtung (10) und dem Substrat (30).
3. Lithografiebelichtungseinrichtung nach Aspekt 1 oder 2, wobei die Belichtungseinrichtung (10) mindestens zwei UV-Laserlichtquellen (11, 17), vorzugsweise mindestens zwei UV-Laserdioden (11, 17) aufweist, die UV-Laserlicht (13) in mindestens zwei unterschiedlichen Wellenlängen im Bereich von 350 nm - 450 nm emittieren, wobei diese UV-Laserdioden vorzugsweise einzeln, weiter bevorzugt paarweise gebündelt über die Ablenkeinrichtung auf das Substrat abgelenkt und/oder einzeln oder paarweise gebündelt angesteuert werden.
4. Lithografiebelichtungseinrichtung nach einem der vorhergehenden Aspekte, mit einer Bildbearbeitungsvorrichtung für bildverarbeitende Maßnahmen, sodass mittels Skalierung, Drehung, Verschiebung und/oder Verkippung (48) das zu belichtende Muster (30) auf dem Substrat (30) verändert bzw. korrigiert werden kann.
5. Lithografiebelichtungseinrichtung nach einem der vorhergehenden Aspekte, wobei die Belichtungseinrichtung (10) eine weitere Lichtquelle, vorzugsweise eine Laserdiode, aufweist, die Licht im infraroten Wellenlängenbereich emittiert, das vorzugsweise über die veränderbare Ablenkeinrichtung (12) auf das Substrat ablenkbar ist.
6. Lithografiebelichtungseinrichtung nach einem der vorhergehenden Aspekte, mit einem optischen Element (16), mit dem das Licht der Lichtquellen der Belichtungseinrichtung (10), vorzugsweise mindestens der mehreren UV-Laserlichtquellen (11) zusammengefasst werden kann, um das Licht über die veränderbare Ablenkeinrichtung (12) auf das Substrat (30) zu richten.
7. Lithografiebelichtungseinrichtung nach einem der vorhergehenden Aspekte, sofern abhängig von Aspekt 2, wobei die Bewegungseinrichtung (20) angepasst ist, um:
   (a) eine Relativbewegung in einer Dimension, vorzugsweise parallel zum Substrat (30) bzw. senkrecht zum Substrat zu ermöglichen, und/oder
   (b) eine Relativbewegung in zwei Dimensionen, vorzugsweise parallel zum Substrat (30), zu ermöglichen, und/oder
   (b) eine Relativbewegung in drei Dimensionen, vorzugsweise parallel und senkrecht zum Substrat (30), zu ermöglichen.
8. Lithografiebelichtungseinrichtungen nach einem der vorhergehenden Aspekte, wobei die veränderbare Ablenkeinrichtung (12) mindestens einen rotierenden bzw. verkippbaren Polygonspiegel aufweist, um das UV-Laserlicht an verschiedene Positionen auf dem Substrat (30) abzulenken, wobei die veränderbare Ablenkeinrichtung (12) vorzugsweise einen ein- oder zweidimensionalen Galvometerscanner aufweist.
9. Verfahren zum lithographischen direkten, vorzugsweise maskenlosen, Belichten eines Musters (40) auf einem Substrat (30), das eine lichtempfindliche Schicht im UV Bereich aufweist, vorzugsweise lichtempfindlich im Bereich von 350 nm - 450 nm, mit den Schritten:
   - Bereitstellen einer Lithografiebelichtungseinrichtung (10) mit mindestens einer Belichtungseinrichtung (10), die eine modulierte Lichtquelle mit einer oder mehreren UV-Laserlichtquellen (11) aufweist, zur Erzeugung eines UV-Laserlichts (13) im Wellenlängenbereich von 350 nm - - 450 nm, vorzugsweise einer Lithografiebelichtungseinrichtung (10) nach einem der vorhergehenden Aspekte;
   - Anordnen des Substrats (30) relativ zur Lithografiebelichtungseinrichtung (10), sodass das von der Belichtungseinrichtung (10) emittierte UV-Laserlicht (13) auf das Substrat gelenkt wird; und
   - Belichten des Substrats (30) mit der Belichtungseinrichtung (10), wobei das Muster (40) mittels einer veränderbaren Ablenkeinrichtung (12) durch zeitlich variables Ablenken des UV-Laserlichts (13) auf dem Substrat erreicht wird.
10. Verfahren nach Aspekt 9, wobei der Abstand zwischen Belichtungseinrichtung (10) und Substrat (30) während der Belichtung verändert wird, wodurch sich die Ausdehnung eines auf dem Substrat (30) erzeugten Belichtungsflecks verändert, wodurch unterschiedlich breite Linien auf dem Substrat (30) belichtet werden.
11. Verfahren nach einem der vorhergehenden Verfahrensaspekte, wobei die variable Ablenkeinrichtung (12) das Licht in den zwei Dimensionen zum Substrat (30) ablenkt, wobei dieser zeitlich variable Ablenkvorgang mit zwei gleichen Oszillationsfrequenzen durchführt wird die 45° zu einer Linearbewegung einer Bewegungseinrichtung (20) ausgerichtet sind, um die Geschwindigkeit der Belichtung um den Faktor ?2 zu erhöhen.
12. Verfahren nach einem der vorhergehenden Verfahrensaspekte, wobei die Geschwindigkeit einer Bewegungseinrichtung (20), zur Erzeugung einer Relativbewegung zwischen der Belichtungseinrichtung (10) und dem Substrat (30), an die Scan-Geschwindigkeit der variablen Ablenkeinrichtung (12) angepasst ist, sodass die Relativbewegung der Belichtungseinrichtung (20) zum Substrat (30) in Abhängigkeit der Scan-Geschwindigkeit durchgeführt wird.
13. Verfahren nach einem der vorhergehenden Verfahrensaspekte, wobei die variable Ablenkeinrichtung (12) für
   eine Ablenkung entlang einer Y-Achse, die in der Ebene des Substrats (30) liegt, eine erste Spiegelstufe in Form eines Galvanometerspiegel aufweist, und
   vorzugsweise für eine Ablenkung entlang einer X-Achse, die in der Ebene des Substrats (30) liegt und senkrecht zur Y-Achse liegt, eine zweite Spiegelstufe aufweist, vorzugsweise in Form eines eindimensionalen elektrisch-magnetisch oszillierenden Mikrospiegels oder in Form eines eindimensional arbeitenden Polygonscanners.
14. Verfahren nach einem der vorhergehenden Verfahrensaspekte, wobei die Belichtungseinrichtung (10) in mehrfacher Anwendung nebeneinander so zueinander aufgebaut wird, dass sich beim Scanvorgang eine geschlossene, um die Anzahl der Belichtungseinrichtungen(19) multiplizierte Scanlinien ergibt.
15. Verfahren nach einem der vorhergehenden Verfahrensaspekte, wobei die Belichtungseinrichtung (10) mit einer Strahlaufweitungsoptik versehen ist, um das kollimierte UV-Laserlicht (13) auf einen größeren, definierten Durchmesser aufzuweiten.

### Kurze Beschreibung der Zeichnungen

Im Folgenden werden bevorzugte Ausführungsformen der vorliegenden Erfindung unter Bezugnahme auf die Figuren ausführlich beschrieben. Es zeigen:
- Fig. 1a & 1b: perspektivische Ansichten einer erfindungsgemäßen Lithographiebelichtungseinrichtung in Form einer Zwei-Achs-Portalanordnung mit einer zweistufigen Projektionseinheit in der Belichtungseinrichtung;
- Fig. 2: ein Blockschaltbild einer Projektionseinheit in einer erfindungsgemäßen Belichtungseinrichtung;

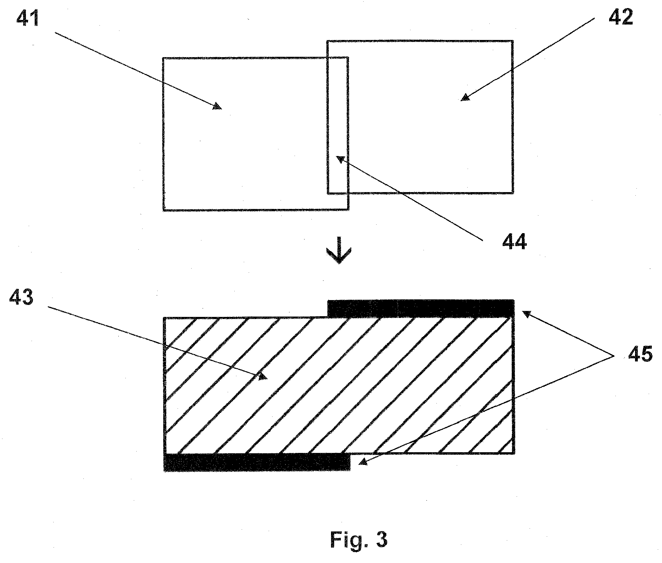

- Fig. 3: eine schematische Darstellung der Einzelbildkorrektur in der Bildebene zweiter Projektionseinheiten einer Belichtungseinheit;
- Fig. 4: eine schematische Darstellung der Einzelbildkorrektur in der Bildebene zweiter Projektionseinheiten einer Belichtungseinheit durch die Vorfilterung der Bilddaten in der Einspeisequelle (z.B. PC); und
- Fig. 5: eine Skizze einer Kopplungseinrichtung zur Kombination von zwei Laserstrahlen.

### Detaillierte Beschreibung bevorzugter Ausführungsformen

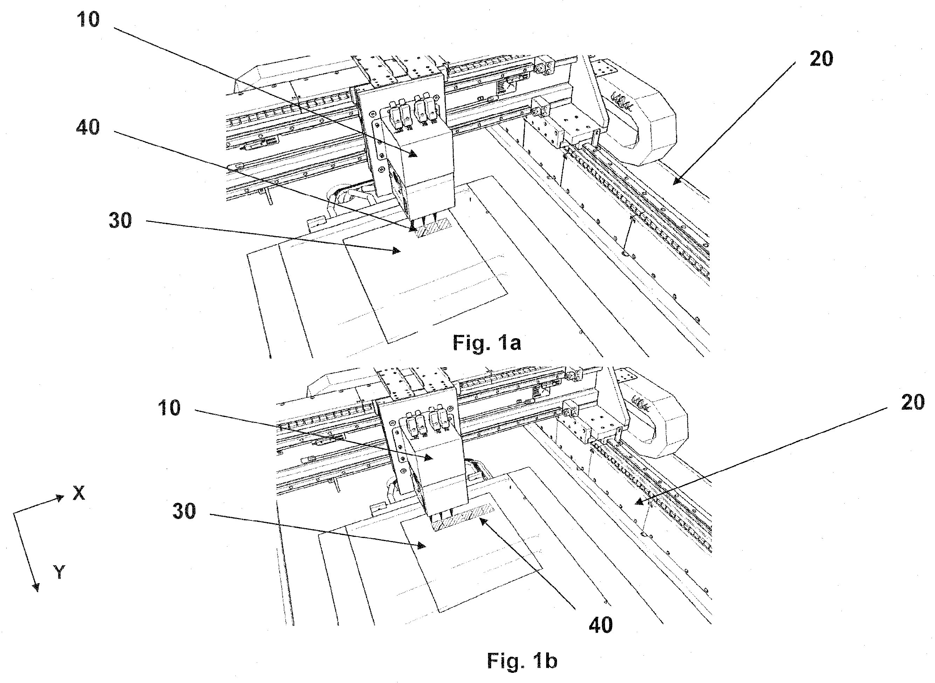

Figur 1 zeigt eine perspektivische Ansicht einer erfindungsgemäßen Lithografiebelichtungseinrichtung mit einer Belichtungseinrichtung 10, die in dieser Ausführungsform mit einer Bewegungseinrichtung 20 gekoppelt ist bzw. an einer Bewegungseinrichtung 20 angebracht ist. Mit Hilfe der Bewegungseinrichtung 20 wird eine Relativbewegung zwischen der Belichtungseinrichtung 10 und dem Substrat 30 erzeugt, wodurch größere Flächen eines Substrats 30 belichtet werden können.

Prinzipiell können kleinere Strukturen im Bereich von wenigen Quadratzentimetern auch mit einer Belichtungseinrichtung 10 erreicht werden die stationär zum Substrat 30 angeordnet ist, wobei die entsprechende Umlenkung des Lichts zur Erzeugung des Musters nur mit Hilfe einer veränderbaren Ablenkeinrichtung 12 erreicht wird (siehe Fig. 1a). Für die Belichtung größerer Strukturen, d.h. größer als einige Quadratzentimetern ist es jedoch bevorzugt, die Relativbewegung der Lichtstrahlen zum zu belichtenden Substrat 30 durch die veränderbare Ablenkeinrichtung 12 und zusätzlich durch die Bewegungseinrichtung 20 zu erreichen. Zudem kann eine erfindungsgemäße Belichtungseinrichtung 10 eine oder mehrere Projektionseinheiten umfassen, wobei vorzugsweise jede Projektionseinheit vorzugsweise mindestens eine eigene Lichtquelle aufweist. Vorzugsweise werden der Begriff Belichtungseinrichtung und Projektionseinheit synonym verwendet, wenn die Belichtungseinrichtung nur eine Projektionseinheit aufweist. Die Lichtquelle (Laserdiode, Halbleiterlaser) wird vorzugsweise mittels Optik(en) hinsichtlich ihres Divergenzwinkels und der Strahlcharakteristik korrigiert. Der Austrittslaserstrahl aus dieser Optikstufe ist vorzugsweise kreisrund. Der Divergenzwinkel kann vorzugsweise stark verringert werden und liegt anschließend vorzugsweise im Bereich < 1° - 5°.

Durch eine Kombinieroptik 16 können mehrere Laserdiodenquellen 11, 17 mit gleichen oder verschiedenen Wellenlängen zusammengeschalten werden. Da die Ausgangsleistung der Laserdiodenquellen 11, 17, insbesondere der Single-Mode Laserdiodenquellen beschränkt ist, kann durch diese Maßnahme der Mehrfacheinkopplung die Einfall-Leistung auf eine Ablenkeinrichtung bzw. einen Spiegel 12 erhöht werden. Zudem ist es möglich, bei Verwendung von Laserdioden mit unterschiedlichen Wellenlängen in einer Belichtungseinrichtung 10 diese gleichzeitig oder simultan zu nutzen. Da Fotoresiste häufig besser im Bereich der i-Line (365 nm) und Lötstoppresiste im Bereich der h-line (405 nm) auf die Strahlung reagieren, birgt diese Kopplung für die Applikation große Vorteile.

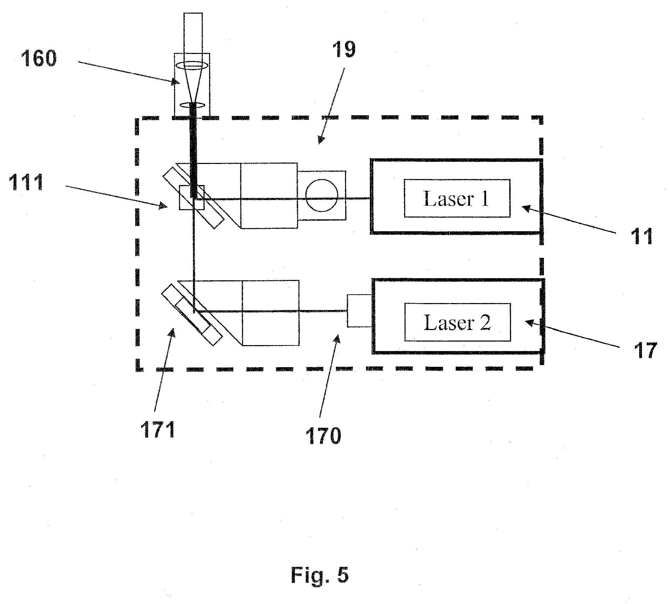

Beispielsweise zeigt die Fig. 5 schematisch eine Ausführungsform wie das Laserlicht eines ersten Lasers 11 mit dem Laserlicht eines zweiten Lasers 17 kombiniert werden kann. Der Laserstrahl des ersten Lasers 11 ist auf einen Polarisationswürfel 111 gerichtet bzw. gelenkt. Vorzugsweise wird der Laserstrahl des ersten Lasers 11 mittels eines optischen Spiegels 19, der vorzugsweise verstellbar oder lateralverstellbar ist, auf den Polarisationswürfel 111 gelenkt. Die Lateralverstellung ermöglicht beispielsweise eine genaue Positionsjustage des Laserstrahls, sodass er vorzugsweise ortsgenau auf den Polarisationswürfel 111 auftrifft. Vorzugsweise ist das Licht des ersten Laserstrahles polarisiert.

Die Polarisation des Laserstrahls des zweiten Lasers 17 wird vorzugsweise über eine Lambda/2 Polarisationsdreheinrichtung gedreht, sodass die Polarisation des zweiten Laserstrahls orthogonal zu der Polarisation des Laserstrahls des ersten Lasers 11 orientiert ist. Nachfolgend wird der zweite Laserstrahl über einen Umlenkspiegel 171 auf den Polarisationswürfel 111 gelenkt und mit dem Strahl des ersten Lasers zusammengeführt. Ausgangsseitig des Polarisationswürfels 111 wird der gekoppelte Laserstrahl über optische Mittel, beispielsweise eine Aufweitungsoptik 160 für die weitere Bearbeitung geformt.

Des Weiteren kann durch die Verwendung der erfindungsgemäßen Belichtungseinrichtung mit mehreren Wellenlängen insbesondere bei Fotodrucklacken mit einer hohen Schichtdicke (z.B. 100 µm) eine bessere Polymerisierung erreicht werden. Dabei sorgt die längere Wellenlänge (z.B. 405nm) für eine Polymerisierung der tieferen Lackschichten und die kürzere Wellenlänge (z.B. 375nm) für die Polymerisierung der oberen Schichten.

Der aus der Kombinieroptik 16 austretende kombinierte UV-Laserstrahl wird auf eine elektrisch ansteuerbare Ablenkeinrichtung 12, vorzugsweise ein in zwei Dimensionen ablenkbares Mirkospiegelpaar, weiter bevorzugt ein einzelner Mikrospiegel, weiter bevorzugt ein Polygonspiegel gelenkt. Durch synchrone Modulation der Laser mit ein- oder mehreren Wellenlängen mit dem Antrieb des Ablenksystems 15 der Ablenkeinrichtung 12 lassen sich beliebige Muster bzw. Bilder unabhängig von der zur erzeugenden Struktur erzeugen.

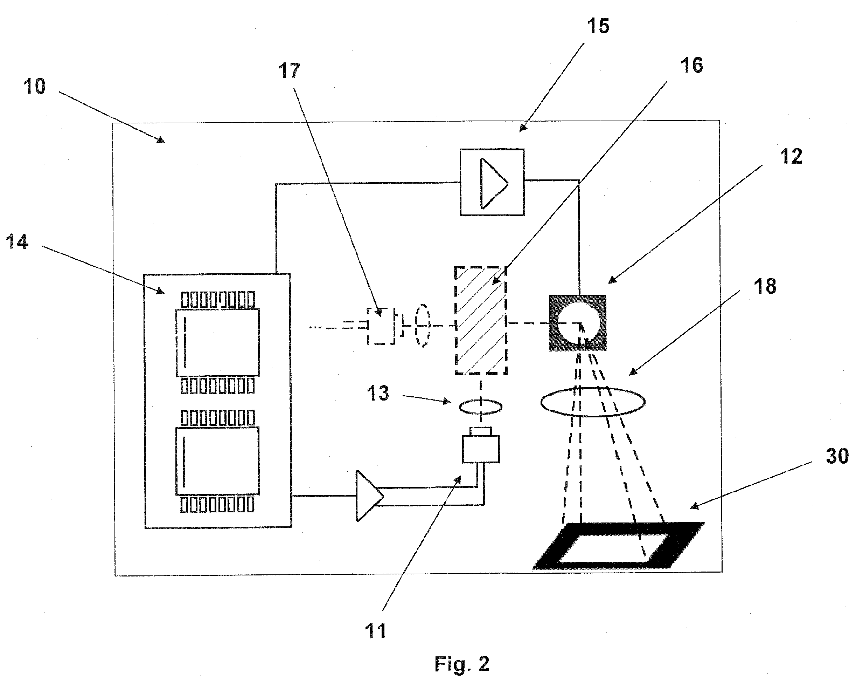

Fig. 2 ist eine schematische Darstellung einer erfindungsgemäßen Belichtungseinrichtung. Entsprechend ist die Belichtungseinrichtung 10 zum direkten Belichten eines Musters bzw. einer Struktur so angepasst, dass das von der Lichtquelle 11 bzw. den Lichtquellen 11, 17 emittierte Licht auf einen Belichtungsfleck auf dem Substrat 30 gebündelt wird, vorzugsweise in einem Brennpunkt auf dem Substrat 30 fokussiert wird. Um die gewünschte Struktur auf dem Substrat 30 zu belichten ist die Lithogratiebelichtungseinrichtung vorzugsweise so angepasst, dass während der Belichtung eine Relativbewegung in zwei Dimensionen (entlang zweier senkrecht zueinander stehender Achsen) stattfinden kann, wobei die Intensität des auf das Substrat 30 auftreffenden Lichtes während der Belichtungseinrichtung 10 veränderbar (steuerbar bzw. modulierbar) ist. Dabei kann diese Relativbewegung entweder direkt durch die zweidimensionale Ablenkung des Laserstrahls und/oder durch die Bewegung der Leiterplatte senkrecht zur Bewegungsrichtung des Laserstrahl erreicht werden.

Der Belichtungsfleck ist vorzugsweise im Wesentlichen näherungsweise rund und hat vorzugsweise einen Durchmesser von ca. 30 µm, weiter bevorzugt einen Durchmesser zwischen 5 - 100 µm und weiter bevorzugt zwischen 15 und 50 µm.

Vorzugsweise wird Licht mit einer Leistung von mindestens 100 mW einer oder mehrerer Laserdioden mit derselben oder unterschiedlichen Wellenlänge, auf das Substrat emittiert.

Die Steuerung der Ablenkeinrichtung erfolgt dabei vorzugsweise gemäß dem vom Benutzer gewünschtem Bild bzw. Layout direkt von der Bildquellenseite (PC). Die digitalen Bildinformationen werden dabei beispielsweise durch eine Ansteuerkarte, eine elektrische Schaltung welche FPGAs mit hoher Rechenleistung und Taktfrequenz zur Generierung der schnellen Ansteuersignale, durchgeführt. Diese elektrischen Signale werden nachfolgend von einer Verstärkerstufe 15 umgesetzt, sodass die Ablenkeinrichtung direkt angesteuert werden kann.

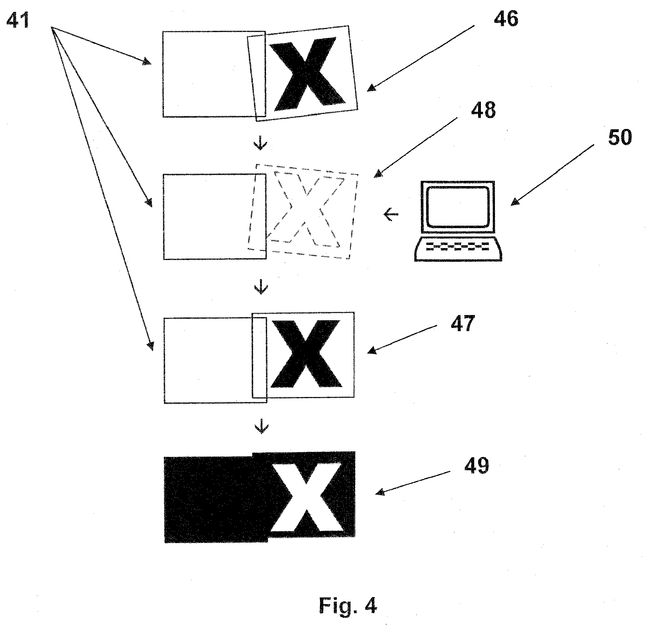

Auftretende Verzerrungen bei der Abbildung durch die Ablenkung des Laserstrahls werden hierbei mittels Kompensation, vorzugsweise in der Bildebene auf der Bildquellenseite (PC) 50, weiter bevorzugt durch Kompensationstabellen in der Ansteuerung der Laserablenkeinrichtung, durchgeführt. Gleichfalls umfasst das Verfahren zur lithographischen Belichtung durch ein- und mehrstufige Lasereinrichtungen mit ein- oder mehreren Wellenlängen die Bildkompensation von mehrstufigen Belichtungseinheiten. Bei mehrstufigen, parallel angeordneten Belichtungseinheiten kommt es aufgrund von Montage- und Fertigungstoleranzen der Optiken zu Dunkelstellen sowie wie in Figur 4 gezeigt, zu Versatz in X und Y Richtung und Verkippungswinkeln der Bilder zueinander. Das erfindungsgemäße Verfahren umfasst vorzugsweise eine Methode der Kombination dieser zueinander inkorrekten Einzelbilder 41,42 zu einem korrigierten Gesamtbild 43.

Hierbei wird vorzugsweise durch die mechanische Montage der Projektionseinheiten bzw. Belichtungseinrichtung 10 zueinander eine Überlappung der Belichtungsbereiche 44 erreicht. Nun ist es möglich zwischen diesen beiden Einzelbildern 41,42 ein resultierendes Gesamtbild 43 mit einer insgesamt minimal reduzierten Fläche zu definieren. Um Doppelbelichtungen an den Randbereichen 44 zu vermeiden, wird anschließend das zweite Bild mit einem Offset in der X/Y Ebene versehen, so dass beide Bilder nahtlos aneinander angeglichen werden. Überstehende Bereiche 45 werden in der Bildebene auf der Einspeisequelle (z.B. PC) 50 geschwärzt oder mit spezifischen Grau-Stufen-Werten hinterlegt, wodurch der Laser beim Scanvorgang innerhalb dieser Bereiche ausgeschalten bzw. abgedunkelt wird. Bei einer Verkippung eines Teilbildes 46 zum vorangegangenen Bild 41 kann auf Seiten der Einspeisequelle (z.B. PC) 50 das abzubildende Bild 47 zunächst vorgefiltert werden und um einen passenden Gegenwinkel 48 vorbearbeitet werden.

Das Belichtungsverfahren arbeitet schließlich in Anlehnung an die Anzahl der Projektionseinheiten bzw. Belichtungseinrichtungen wie folgt: Das Gesamtbild der zu belichtenden Fläche wird in Einzelbilder aufgeteilt. Das Einzelbild entspricht der Größe der zu kalibrierenden Gesamtfläche 43 in Abhängigkeit der Anzahl an Projektionseinheiten. Wie in Figur 1 gezeigt positioniert sich die Belichtungseinheit 10 durch ein elektrisch angetriebenes X/Y Portalsystem 20 über das Substrat 30. Gespeist durch eine oder mehrere Einspeisequelle 50 (z.B. PC) gelangen die vorgefilterten Einzelbilder zu den Projektionseinheiten. Diese belichten, vorzugsweise synchronisiert durch das Erreichen der Zielposition des X/Y Portalsystem 20 die maximal abbildbare Fläche in Abhängigkeit der Brennlinse 18 und des Kippwinkels des Mikrospiegels 12. Nach Beendigung des Belichtungsvorganges fährt das X/Y Portalsystem 20 die Position des nächsten Einzelbildes vorzugsweise mit einer absoluten Positioniergenauigkeit im Bereich von +/- 5 µm an und das nächste Einzelbild wird belichtet.

Bei einer weiter bevorzugter Arbeitsweise wird die erfindungsgemäße Belichtungseinrichtung 10 während des Belichtungsvorgangs durch das X/Y Portalsystem 20 konstant über dem Substrat 30 bewegt und belichtet einen bzw. mehrere Streifen, dessen Breite von der verwendeten Ablenkeinrichtung sowie von den verwendeten optischen Mitteln abhängt. Die einzelnen Streifen werden mittels des X/Y Portalsystems 20 zusammengesetzt und somit das gesamte Substrat 30 belichtet.

Weiter bevorzugt, kann die Breite eines Belichtungsstreifens die gesamte Substratbreite umfassen und somit die notwendige Fläche in einem Schritt belichten.

Vorzugsweise wird das Substrat 30, aus dem nach Belichtungs-, Entwicklungs- und Ätzverarbeitungsschritten eine Leiterplatte hergestellt wird, von einer Aufnahme aufgenommen. Die Aufnahme kann Einrichtungen aufweisen zur temporären Fixierung des Substrats, wie Klammern oder Verspannvorrichtungen. Alternativ oder zusätzlich kann die Aufnahme eine Unterdruckeinrichtung aufweisen, wodurch das Substrat an die Aufnahme angesaugt wird.

Vorzugsweise ist die Aufnahme mit dem Substrat ortsfest bzw. stationär angeordnet und die Belichtungseinrichtung wird während der Belichtung bewegt. Es ist jedoch auch möglich, dass die Belichtungseinrichtung ortsfest bzw. stationär angeordnet ist und das Substrat während der Belichtung bewegt wird. Dies kann beispielsweise durch eine bewegbare Aufnahme erreicht werden. Zudem ist eine Kombination beider Bewegungen möglich, d.h., sowohl die Aufnahme als auch die Belichtungseinrichtung sind bewegbar. Auch ist es denkbar, dass die Belichtungseinrichtung während der Belichtung bewegt wird, um das gewünschte Muster auf die lichtempfindliche Schicht zu belichten und die Aufnahme lediglich zwischen Belichtungsschritten bewegt wird, beispielsweise zum Zuführen eines neuen Substrats.

## Patentansprüche

1. Lithografiebelichtungseinrichtung zum lithographischen direkten maskenlosen Belichten eines Musters (40) auf einem Substrat (30), das eine lichtempfindliche Schicht aufweist, mit:
einer Belichtungseinrichtung (10), die eine modulierbare Lichtquelle mit einer oder mehreren UV-Laserlichtquellen (11, 17) aufweist, zur Erzeugung eines UV-Laserlichts (13) im Wellenlängenbereich von 350 nm - 450 nm; und
einer veränderbaren Ablenkeinrichtung (12), die geeignet ist, durch Ablenken des UV-Laserlichts (13), das Muster (40) auf dem Substrat (30) zu belichten,
wobei die veränderbare Ablenkeinrichtung (12) einen ein- oder zweidimensionalen Galvometerscanner aufweist.

2. Lithografiebelichtungseinrichtung nach Anspruch 1, wobei die variable Ablenkeinrichtung (12) für eine Ablenkung entlang einer Y-Achse, die in der Ebene des Substrats (30) liegt, eine erste Spiegelstufe in Form eines Galvanometerspiegel aufweist, und/oder
für eine Ablenkung entlang einer X-Achse, die in der Ebene des Substrats (30) liegt und senkrecht zur Y-Achse liegt, eine zweite Spiegelstufe aufweist, in Form eines eindimensionalen elektrisch-magnetisch oszillierenden Mikrospiegels oder in Form eines eindimensional arbeitenden Polygonscanners.

3. Lithografiebelichtungseinrichtung nach Anspruch 1 oder 2, wobei eine Ablenkeinrichtung ein Akusto-optischer-Modulator (AOM) ist, um die Intensität and/oder die Richtung des von der UV-Laserlichtquelle emittierten Laserstrahls zu ändern.

4. Lithografiebelichtungseinrichtung nach einem der Ansprüche 1 bis 3, zusätzlich mit einer Bewegungseinrichtung (20) zur Erzeugung einer Relativbewegung zwischen der Belichtungseinrichtung (10) und dem Substrat (30).

5. Lithografiebelichtungseinrichtung nach einem der vorhergehenden Ansprüche, wobei die Belichtungseinrichtung (10) mindestens zwei UV-Laserlichtquellen (11, 17), vorzugsweise mindestens zwei UV-Laserdioden (11, 17) aufweist, die UV-Laserlicht (13) in mindestens zwei unterschiedlichen Wellenlängen im Bereich von 350 nm - 450 nm emittieren, wobei diese UV-Laserdioden vorzugsweise einzeln, weiter bevorzugt paarweise gebündelt über die Ablenkeinrichtung auf das Substrat abgelenkt und/oder einzeln oder paarweise gebündelt angesteuert werden.

6. Lithografiebelichtungseinrichtung nach einem der vorhergehenden Ansprüche, mit einer Bildbearbeitungsvorrichtung für bildverarbeitende Maßnahmen, sodass mittels Skalierung, Drehung, Verschiebung und/oder Verkippung (48) das zu belichtende Muster (30) auf dem Substrat (30) verändert bzw. korrigiert werden kann.

7. Lithografiebelichtungseinrichtung nach einem der vorhergehenden Ansprüche, wobei die Belichtungseinrichtung (10) eine weitere Lichtquelle, vorzugsweise eine Laserdiode, aufweist, die Licht im infraroten Wellenlängenbereich emittiert, das vorzugsweise über die veränderbare Ablenkeinrichtung (12) auf das Substrat ablenkbar ist.

8. Lithografiebelichtungseinrichtung nach einem der vorhergehenden Ansprüche, mit einem optischen Element (16), mit dem das Licht der Lichtquellen der Belichtungseinrichtung (10), vorzugsweise mindestens der mehreren UV-Laserlichtquellen (11) zusammengefasst werden kann, um das Licht über die veränderbare Ablenkeinrichtung (12) auf das Substrat (30) zu richten.

9. Lithografiebelichtungseinrichtung nach einem der vorhergehenden Ansprüche, sofern abhängig von Anspruch 4, wobei die Bewegungseinrichtung (20) angepasst ist, um:
(a) eine Relativbewegung in einer Dimension, vorzugsweise parallel zum Substrat (30) bzw. senkrecht zum Substrat zu ermöglichen, und/oder
(b) eine Relativbewegung in zwei Dimensionen, vorzugsweise parallel zum Substrat (30), zu ermöglichen, und/oder
(b) eine Relativbewegung in drei Dimensionen, vorzugsweise parallel und senkrecht zum Substrat (30), zu ermöglichen.

10. Verfahren zum lithographischen direkten maskenlosen Belichten eines Musters (40) auf einem Substrat (30), das eine lichtempfindliche Schicht im UV Bereich aufweist, mit den Schritten:
- Bereitstellen einer Lithografiebelichtungseinrichtung (10) nach einem der vorhergehenden Ansprüche;
- Anordnen des Substrats (30) relativ zur Lithografiebelichtungseinrichtung (10), sodass das von der Belichtungseinrichtung (10) emittierte UV-Laserlicht (13) auf das Substrat gelenkt wird; und
- Belichten des Substrats (30) mit der Belichtungseinrichtung (10), wobei das Muster (40) mittels einer veränderbaren Ablenkeinrichtung (12) durch zeitlich variables Ablenken des UV-Laserlichts (13) auf dem Substrat erreicht wird,
wobei die variable Ablenkeinrichtung (12) für
eine Ablenkung entlang einer Y-Achse, die in der Ebene des Substrats (30) liegt, eine erste Spiegelstufe in Form eines Galvanometerspiegel aufweist, und
für eine Ablenkung entlang einer X-Achse, die in der Ebene des Substrats (30) liegt und senkrecht zur Y-Achse liegt, eine zweite Spiegelstufe aufweist, in Form eines Galvanometerspiegels, eines eindimensionalen elektrisch-magnetisch oszillierenden Mikrospiegels oder in Form eines eindimensional arbeitenden Polygonscanners.

11. Verfahren nach Anspruch 10, wobei der Abstand zwischen Belichtungseinrichtung (10) und Substrat (30) während der Belichtung verändert wird, wodurch sich die Ausdehnung eines auf dem Substrat (30) erzeugten Belichtungsflecks verändert, wodurch unterschiedlich breite Linien auf dem Substrat (30) belichtet werden.

12. Verfahren nach einem der vorhergehenden Verfahrensansprüche, wobei die variable Ablenkeinrichtung (12) das Licht in den zwei Dimensionen zum Substrat (30) ablenkt, wobei dieser zeitlich variable Ablenkvorgang mit zwei gleichen Oszillationsfrequenzen durchführt wird die 45° zu einer Linearbewegung einer Bewegungseinrichtung (20) ausgerichtet sind, um die Geschwindigkeit der Belichtung um den Faktor √2 zu erhöhen.

13. Verfahren nach einem der vorhergehenden Verfahrensansprüche, wobei die Geschwindigkeit einer Bewegungseinrichtung (20), zur Erzeugung einer Relativbewegung zwischen der Belichtungseinrichtung (10) und dem Substrat (30), an die Scan-Geschwindigkeit der variablen Ablenkeinrichtung (12) angepasst ist, sodass die Relativbewegung der Belichtungseinrichtung (20) zum Substrat (30) in Abhängigkeit der Scan-Geschwindigkeit durchgeführt wird.

14. Verfahren nach einem der vorhergehenden VerfahrensAnsprüche, wobei die Belichtungseinrichtung (10) in mehrfacher Anwendung nebeneinander so zueinander aufgebaut wird, dass sich beim Scanvorgang eine geschlossene, um die Anzahl der Belichtungseinrichtungen(19) multiplizierte Scanlinien ergibt.

15. Verfahren nach einem der vorhergehenden VerfahrensAnsprüche, wobei die Belichtungseinrichtung (10) mit einer Strahlaufweitungsoptik versehen ist, um das kollimierte UV-Laserlicht (13) auf einen größeren, definierten Durchmesser aufzuweiten.
